# EUROPEAN PATENT APPLICATION

(11) **EP 4 783 202 A1**
(43) Date of publication of application: **29.07.2026**
(21) Application number: 26153607.2
(22) Date of filing: 22.01.2026
(51) Int. Cl.: H01F 27/02, H02G 3/04

(54) **A CONDUCTOR PASS-THROUGH DEVICE FOR MANAGEMENT OF THERMAL CONDITIONS WITHIN A DATA CENTER**

(30) Priority: 28.01.2025 US 202563750617 P; 31.10.2025 US 202519375526
(71) Applicant: Vertiv Corporation, Westerville, OH 43082 (US)
(72) Inventor: JOHNSON, Logan Tyler, 43082 Westerville (US); CALDWELL, Carl Robert, 43082 Westerville (US); WILCOXEN, Zachary Ray, 43082 Westerville (US)
(74) Representative: Ambroz, Simon

(57) **Abstract**

Systems and methods for providing consistent and reliable thermal insulation for electrical components that are proximate to a transformer within an overall data center environment that is executing high-power and variable high-performance computing (HPC) and/or artificial intelligence (AI) workloads are disclosed. By installing a conductor pass-through device that both enables electrical cables to connect to the transformer via channels in the device and also provides thermal insulation against excess heat being emitted from the transformer, the other electrical components stay within their normal operating temperature ranges and do no overheat.

## Description

### CROSS-REFERENCE TO RELATED APPLICATIONS

This application claims the benefit of and priority to U.S. Provisional Patent Application No. 63/750,617, filed January 28, 2025, and U.S. Nonprovisional Patent Application No. 19/375,526, filed 31 October 2025.

### TECHNICAL FIELD

This disclosure relates to a device for providing thermal insulation of a transformer.

### BACKGROUND

Data center environments have to balance the usage of a large range of power, due, at least in part, to a variety of electronic components within the data center and their specifications. Measures are taken to also ensure that each of those electronic components operates within its designated temperature ranges both to allow for optimization of computing resources of the data center and to avoid possible overheating or degradation of those electronic components. However, previous measures that were taken to attempt to resolve this issue have failed to effectively manage the different designated temperature ranges of electronic components that are physically proximate to one another within the overall data center environment.

### SUMMARY

An aspect of the disclosed embodiment includes a system for managing high-power and variable workloads at a data center. The system includes: a transformer; electrical components; electrical cables, configured to connect the electrical components to the transformer; and a conductor pass-through device, located between the transformer and the electrical components, wherein: the conductor pass-through device is configured to provide thermal insulation for the electrical components against excess heat emitted from the transformer; and the conductor pass-through device comprises a set of channels that enable respective ones of the electrical cables to pass from a top surface of the conductor pass-through device through a bottom surface of the conductor pass-through device.

### BRIEF DESCRIPTION OF THE DRAWINGS

The disclosure is best understood from the following detailed description when read in conjunction with the accompanying drawings. It is emphasized that, according to common practice, the various features of the drawings are not to-scale. On the contrary, the dimensions of the various features are arbitrarily expanded or reduced for clarity.
FIG. 1 is a schematic that illustrates a conductor pass-through device that provides a thermal insulation barrier for a transformer, according to some embodiments.
FIG. 2 illustrates a zoomed-in portion of the schematic introduced in FIG. 1, according to some embodiments.
FIG. 3 illustrates an example implementation of a conductor pass-through device that provides a thermal insulation barrier for a transformer, according to some embodiments.
FIG. 4 is another schematic that illustrates a conductor pass-through device that provides a thermal insulation barrier for a transformer, according to some embodiments.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described herein in detail.

It may be understood that the example embodiments described herein may be considered in a descriptive sense only and not for purposes of limitation. Descriptions of features or aspects within each example embodiment may be considered as available for other similar features or aspects in other example embodiments.

The rapid development of advanced calculation systems, driven by high-performance computing (HPC), artificial intelligence (AI), and other advanced computing techniques, has changed the pattern of power demand within the data center that hosts the computing devices capable of executing those HPC or AI workloads. As that power density increases and fluctuates, however, so does the amount of heat produced from power dissipation. Moreover, as various electrical components that are collectively configured to execute the HPC or AI workloads have different respective operating temperature tolerances, a need to isolate certain electrical components from sources of excess heat, such as from other electrical components with higher operating temperature tolerances, arises.

In a given example, a component that is responsible for excessive heat generation within a data center environment is a transformer. While a transformer is a key device within the overall operation of a data center, other key devices and components, such as circuit breakers and cables, should be thermally isolated from the excessive heat generation of the transformer in order to stay within their considerably lower temperature tolerances than those of the transformer. Furthermore, conductors that couple the transformer to other components must still be configured to be connected to the transformer while also not radiating excess heat into areas where there are components with considerably lower operating temperature tolerances that those of the transformer.

The present disclosure thus pertains to systems and methods for providing thermal and electrical insulation between a transformer and other electrical components within a data center that is configured to execute large-scale and variable workloads. More specifically, a conductor pass-through device comprises a flexible, thermally and electrically insulating sheet of material that both (1) enables electrical cables to pass between the local environment surrounding the transformer through to an environment that is external to the transformer, e.g., where other electrical components are located, and that (2) thermally insulates those electrical components within the environment that is external to the transformer from the excessive heat generation that is produced by the transformer in the local environment surrounding the transformer. By thermally insulating those other electrical components from hot air that radiates from the transformer, an overall increase in power density within the data center is obtained, while also ensuring that both the transformer and the other electrical components of the data center stay within their respective safe operating temperatures.

As used herein, a cable gland refers to a thermally and electrically insulating sheet of material. The cable gland thus refers to a base material that the conductor pass-through device is fabricated from, wherein the cable gland is further altered to have channels sliced or otherwise perforated through the cable gland, such that electrical cables can pass through the overall conductor pass-through device.

Moreover, and in addition to being thermally and electrically insulating, the cable gland is made of a non-rigid, flexible material. For example, the cable gland may be made of flexible Lexan^{™}, or some other similar type of polycarbonate plastic.

Past attempts to thermally insulate electrical components from excess heat from a transformer used rigid thermally and electrically insulating materials, e.g., a brush shield, that caused stress onto the cables that are passed through the material. In the case of the brush shield specifically, the brush shield loosened over time under prolonged exposure to high temperatures, and was therefore at risk of falling onto sensitive electrical components themselves. Thus, past attempts were both inefficient at shielding electrical components from prolonged heat exposure, and also had finite lifetimes before the materials had to be replaced completely.

In contrast to those inefficient rigid materials and implementations, the present disclosure implements a flexible material, e.g., Lexan^{™}, that can be sliced or perforated for easy pass through of electrical cables. Moreover, the flexible material does not put stress onto the cables, and is also easier to manipulate and adjust after installation.

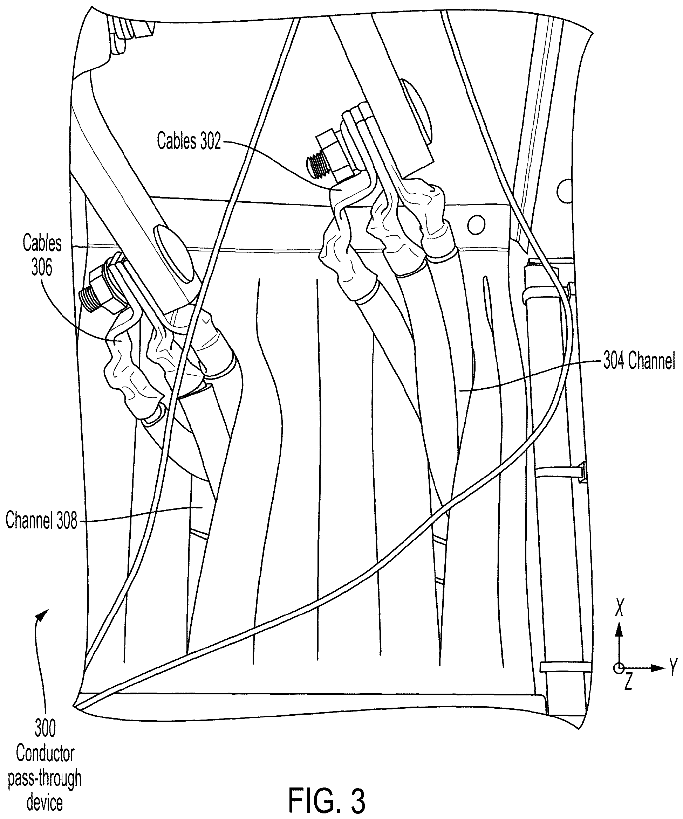

As used herein, a conductor pass-through device may be defined as a three-dimensional (3D) structure with multiple through holes, slits, or any other type of portions of the overall 3D structure that enable one or more cables to pass from a top surface of the conductor pass-through device through a bottom surface of the conductor pass-through device. As such, the cables pass through the entire thickness dimension (see, for example, the three dimensions of the 3D structure defined within FIG. 3 and the corresponding description herein) of the pass-through device, both unhindered and unblocked. The other portions of the overall 3D structure thus have a same thickness dimension and are manufactured using a thermally and electrically insulating material, but do not constitute holes or other means for the cables to pass through from the top to the bottom surface. It should similarly be understood, therefore, that a conductor pass-through device has both at least one "portion" of the 3D structure that enables one or more cables to pass from the top surface of the conductor pass-through device through the bottom surface of the conductor pass-through device and at least one "other portion" of the 3D structure that refers to a section of the device wherein cables cannot pass from the top through to the bottom surface, and is manufactured using a thermally and electrically insulating material.

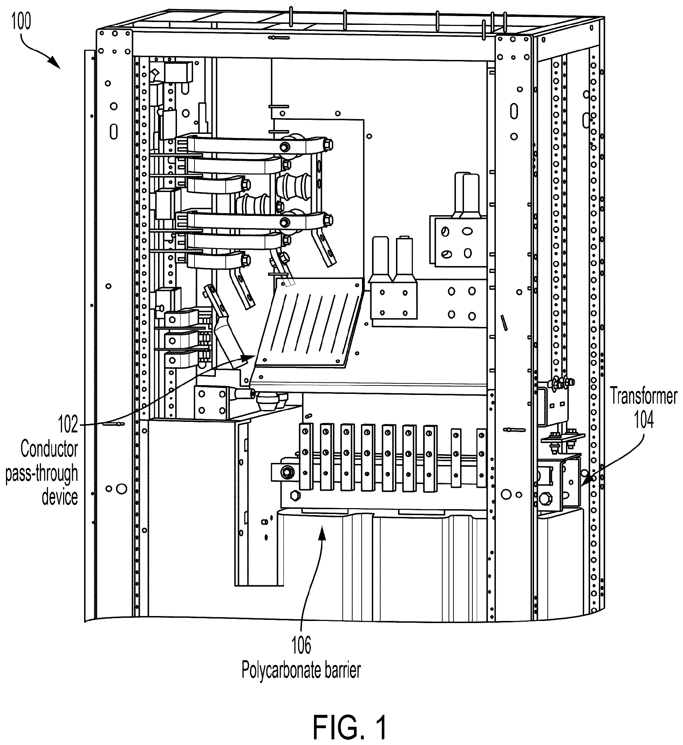

FIG. 1 is a schematic that illustrates a conductor pass-through device that provides a thermal insulation barrier for a transformer, according to some embodiments.

FIG. 1 illustrates a transformer 104 and several distinct environments within an overall Bypass Distribution Cabinet (BDC) 100. For ease of discussion herein, the schematic shown in FIG. 1 has been drawn using a Computer-aided Design (CAD) software that simulates an actual BDC, such as a Vertiv^{™} Liebert^{®} APM2 BDC model. Additionally, various electrical cables and other components that may normally be located within the BDC 100 are not shown in this particular diagram, in order to focus the below discussion on locations of a transformer 104 and a conductor pass-through device 102.

In some embodiments, the BDC 100 may resemble a 3D frame manufactured using galvanized steel. In addition to including the conductor pass-through device 102 and the transformer 104, the BDC 100 may also include one or more removable cable trays that may connect one or more electronic components within the BDC 100 to one another, and to power distribution cables. Furthermore, the BDC 100 may be configured for convection cooling, wherein heat rejection occurs through a screened protective top surface of the 3D frame. In order to supply power into and out of the BDC 100, such as for connection of input power conductors and a parity-sized insulated ground conductor, input power terminal blocks or bus bar may additionally be configured within the BDC 100.

The transformer 104 that is illustrated in FIG. 1 may resemble an electrostatically shielded insulation transformer with a storage temperature range of -67°F to 185°F (-55°C to 85°C) and an operating temperature range of 32°F to 104°F (0°C to 40°C), according to some embodiments. The transformer 104 may additionally resemble a dry-type, double-shielded, three-phase, common-core, convection air-cooled transformer, with a 302°F (150°C) maximum temperature rise and transformer windings made of copper.

In some embodiments, the BDC 100 additionally includes a method for ensuring thermal overload protection for the transformer 104 itself, in which an alarm may sound or otherwise notify personnel if a current temperature of transformer 104 reaches or exceeds 356°F (180°C), and power to the BDC 100 may be cut off if a current temperature of the transformer 104 reaches or exceeds 392°F (200°C). Temperature sensors may be located in each coil of three phase windings of the transformer 104 in order to monitor a temperature of the environment that is local to transformer 104.

Circuit breakers and cables within the BDC 100, which operate at approximately 104°F, are thermally isolated from the excessive heat generation of the transformer 104 in order to stay within their considerably lower temperature tolerances than those of the transformer. For reference, a given transformer 104 within a larger data center environment may operate between 500kVA to 2,000 kVA, thus producing 50W per kVA. Other components, such as the circuit breakers and cables, are thus thermally isolated via the conductor pass-through devices described herein.

FIG. 1 additionally illustrates the conductor pass-through device 102 that is located proximate to the transformer 104. The conductor pass-through device 102 may have a 3D structure that is manufactured using an electrically and thermally insulating material, as introduced above. As further illustrated in the figure, certain portions of the electrically and thermally insulating material have been removed in order to manufacture small holes, narrow slits, or other gaps in the material that enable for electrical cables to fit through. These "channels" through the conductor pass-through device 102 enable those electrical cables to interface with the transformer 104. The holes or slits may be configured to be narrow with respect to a length and/or width dimension of the conductor pass-through device, such that the remaining amount of electrically and thermally insulating material blocks airflow and heat from radiating from the transformer 104 into other areas of the BDC 100.

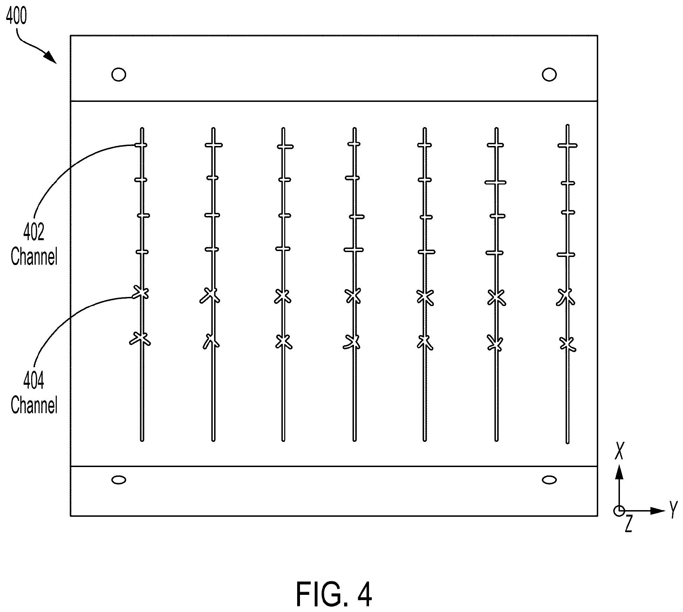

Examples of the different types of narrow slits and their design patterns are additionally shown in FIGS. 3 and 4 herein. Moreover, and within a same conductor pass-through device 102, some of the channels may be of different shapes or sizes in order to fit different cable sizes, or a bus bar, through those channels.

FIG. 1 further illustrates a clear, polycarbonate resin thermoplastic, referred to as polycarbonate barrier 106 in the figure. The polycarbonate barrier 106 may be implemented using a flexible Lexan^{™}, according to some embodiments. The polycarbonate barrier 106 provides additional thermal insulation of other electrical components within the BDC 100 from excess heat emitted from the transformer 104.

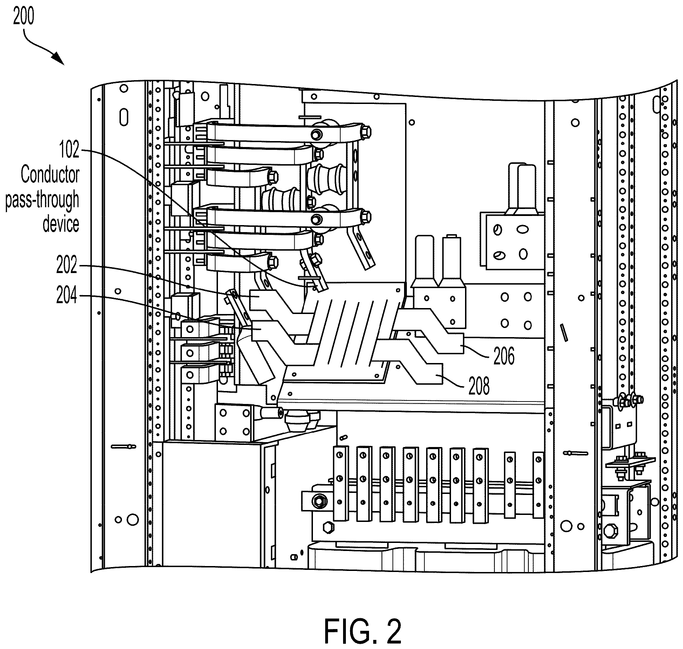

FIG. 2 illustrates a zoomed-in portion 200 of the schematic introduced in FIG. 1, according to some embodiments.

As additionally shown in FIG. 2, electrical cables 202, 204, 206, and 208 are passing through the conductor pass-through device 102 through respective slits in the conductor pass-through device 102.

It should be understood that one or more electrical cables 202, 204, 206, and 208 may be inserted through any given one of the slits, through holes, or other perforations shown in the conductor pass-through device. In some embodiments, no cable(s) may pass through a given one of the slits, as also illustrated in FIG. 2.

FIG. 3 illustrates an example implementation of a conductor pass-through device 300 that provides a thermal insulation barrier for a transformer, according to some embodiments.

As shown in FIG. 3, cables 302 fit through a first channel 304 of the conductor pass-through device 300 and cables 306 fit through a second channel 308 of the conductor pass-through device 300. In some embodiments, the example implementation shown in FIG. 3 may be realized within a larger system or structure, such as the BDC 100 shown in FIGS. 1 and 2.

The particular example in FIG. 3 shows three cables 302 passing through the first channel 304 and three cables 306 passing through the second channel 308. However, in other embodiments, each single cable of cables 302 may be passed through a single (and different) channel of conductor pass-through device 300, and each single cable of cables 304 may be passed through other single (and different) channels of conductor pass-through device 300. Such implementation choices may be determined, based at least in part, on an amount of excess heat from the transformer 104 that is expected to need to be insulated from other electrical components within the BDC 100 during operation.

For ease of discussion herein, a Key with *XYZ* axes may be used to reference the various dimensions of the 3D structural design of the conductor pass-through device 300. As shown in FIG. 3, the channels, e.g., channels 306 and 308, are designed as length-wise slits, which have been cut along the *X* axis. However, in other embodiments of the conductor pass-through device 300, the channels may be designed as width-wise slits, which would be cut along the *Y* axis (see also the example illustrated in FIG. 4). The *X* and *Y* dimensions of the conductor pass-through device 300 may be used to refer to the top and bottom surfaces of the conductor pass-through device 300, wherein each surface is a planar surface.

The Z dimension is thus used to denote the thickness of the conductor pass-through device 300, wherein, since each of the channels, e.g., channels 306 and 308, of device 300 have been cut clear through the top and bottom surface, the channels themselves also have the same thickness as the conductor pass-through device 300 itself.

FIG. 4 is another schematic that illustrates a conductor pass-through device 400 that provides a thermal insulation barrier for a transformer, according to some embodiments.

A similar Key with *XYZ* axes may also be used to reference the various dimensions of the 3D structural design of the conductor pass-through device 400. As shown in FIG. 4, a first set of channels, e.g., channel 402, are designed as small, width-wise slits, which have been cut along the *Y* axis, and a second set of channels, e.g., channel 404, are designed as crosshatches, which have been cut neither exactly along the *X* axis nor the *Y* axis, e.g., at approximately 45° angles to both the *X* axis and the *Y* axis. This may also be referred to as crosshatches which are oriented such that they are offset from both the *X* axis and the *Y* axis. As before with the conductor pass-through device 300, the *X* and *Y* dimensions of the conductor pass-through device 400 may be used to refer to the top and bottom surfaces of the conductor pass-through device 400, wherein each surface is a planar surface.

The Z dimension is thus used to denote the thickness of the conductor pass-through device 400, wherein, since each of the channels of the conductor pass-through device 400 have been cut clear through the top and bottom surface, the channels themselves also have the same thickness as the conductor pass-through device 400 itself.

FIGS. 3 and 4 illustrate the versatility of channel designs themselves, and of the ability to combine different channel designs into a single conductor pass-through device, according to various implementation needs of the environment that is proximate to the conductor pass-through device (e.g., BDC 100). For example, the use of small, width-wise slits and/or crosshatches may allow for the top and bottom surfaces of a given conductor pass-through device to remain more planar, thus further optimizing thermal insulation properties of the device.

Described herein are also the following clauses:
1. A system, comprising: a transformer;
   electrical components;
   electrical cables, configured to connect the electrical components to the transformer; and
   a conductor pass-through device, located between the transformer and the electrical components, wherein:
      the conductor pass-through device is configured to provide thermal insulation for the electrical components against excess heat emitted from the transformer; and
      the conductor pass-through device comprises a set of channels that enable respective ones of the electrical cables to pass from a top surface of the conductor pass-through device through a bottom surface of the conductor pass-through device.
2. The system of clause 1, wherein:
   the top surface and the bottom surface of the conductor pass-through device are planar surfaces, respectively, with a first length and a first width; and
   the conductor pass-through device has a first thickness, between the top surface and the bottom surface.
3. The system of clause 2, wherein the channels, respectively, have:
   a second length, wherein the second length is less than the first length;
   a second width, wherein the second width is less than the second length; and
   the first thickness.
4. The system of clause 3, wherein the channels comprise length-wise channels.
5. The system of clause 3, wherein the channels comprise width-wise channels.
6. The system of clause 3, wherein the channels comprise crosshatch channels, offset from an axis of the first length and another axis of the first width.
7. The system of any preceding clause, wherein the conductor pass-through device comprises a thermally insulating material.
8. The system of any preceding clause, wherein the conductor pass-through device comprises an electrically insulating material.
9. The system of any preceding clause, wherein the conductor pass-through device comprises a polycarbonate plastic.
10. The system of any preceding clause, wherein the conductor pass-through device comprises a non-rigid material.
11. A conductor pass-through device, comprising:
   a top surface;
   a bottom surface; and
   a set of channels that enable electrical cables to pass from the top surface through the bottom surface, wherein:
      the conductor pass-through device is located in between a transformer and electrical components; and
      the conductor pass-through device is configured to provide thermal insulation for the electrical components against excess heat emitted from the transformer.
12. The conductor pass-through device of clause 11, wherein:
   the top surface and the bottom surface are planar surfaces, respectively, with a first length and a first width; and
   the conductor pass-through device has a first thickness, between the top surface and the bottom surface.
13. The conductor pass-through device of clause 12, wherein the channels, respectively, have:
   a second length, wherein the second length is less than the first length;
   a second width, wherein the second width is less than the second length; and
   the first thickness.
14. The conductor pass-through device of clause 13, wherein the channels comprise length-wise channels.
15. The conductor pass-through device of any clause 13 to 14, wherein the channels comprise width-wise channels.
16. The conductor pass-through device of clause 13 to 15, wherein the channels comprise crosshatch channels, offset from an axis of the first length and another axis of the first width.
17. The conductor pass-through device of any clause 11 to 16, wherein the conductor pass-through device comprises a thermally insulating material.
18. The conductor pass-through device of any clause 11 to 17, wherein the conductor pass-through device comprises an electrically insulating material.
19. The conductor pass-through device of any clause 11 to 18, wherein the conductor pass-through device comprises a polycarbonate plastic.
20. The conductor pass-through device of any clause 11 to 19, wherein the conductor pass-through device comprises a non-rigid material.

## Claims

1. A system, comprising:
a transformer;
electrical components;
electrical cables, configured to connect the electrical components to the transformer; and
a conductor pass-through device, located between the transformer and the electrical components, wherein:
the conductor pass-through device is configured to provide thermal insulation for the electrical components against excess heat emitted from the transformer; and
the conductor pass-through device comprises a set of channels that enable respective ones of the electrical cables to pass from a top surface of the conductor pass-through device through a bottom surface of the conductor pass-through device.

2. The system of claim 1, wherein:
the top surface and the bottom surface of the conductor pass-through device are planar surfaces, respectively, with a first length and a first width; and
the conductor pass-through device has a first thickness, between the top surface and the bottom surface.

3. The system of claim 2, wherein the channels, respectively, have:
a second length, wherein the second length is less than the first length;
a second width, wherein the second width is less than the second length; and
the first thickness.

4. The system of claim 3, wherein the channels comprise length-wise channels.

5. The system of claim 3, wherein the channels comprise width-wise channels.

6. The system of claim 3, wherein the channels comprise crosshatch channels, offset from an axis of the first length and another axis of the first width.

7. The system of any preceding claim, wherein the conductor pass-through device comprises a thermally insulating material;
and optionally, wherein the conductor pass-through device comprises an electrically insulating material.
and optionally, wherein the conductor pass-through device comprises a polycarbonate plastic.

8. The system of any preceding claim, wherein the conductor pass-through device comprises a non-rigid material.

9. A conductor pass-through device, comprising:
a top surface;
a bottom surface; and
a set of channels that enable electrical cables to pass from the top surface through the bottom surface, wherein:
the conductor pass-through device is located in between a transformer and electrical components; and
the conductor pass-through device is configured to provide thermal insulation for the electrical components against excess heat emitted from the transformer.

10. The conductor pass-through device of claim 9, wherein:
the top surface and the bottom surface are planar surfaces, respectively, with a first length and a first width; and
the conductor pass-through device has a first thickness, between the top surface and the bottom surface.

11. The conductor pass-through device of claim 10, wherein the channels, respectively, have:
a second length, wherein the second length is less than the first length;
a second width, wherein the second width is less than the second length; and
the first thickness.

12. The conductor pass-through device of claim 11, wherein the channels comprise length-wise channels; or.
wherein the channels comprise width-wise channels; or
wherein the channels comprise crosshatch channels, offset from an axis of the first length and another axis of the first width.

13. The conductor pass-through device of claim 9, wherein the conductor pass-through device comprises a thermally insulating material.

14. The conductor pass-through device of claim 9, wherein the conductor pass-through device comprises an electrically insulating material;
and optionally, wherein the conductor pass-through device comprises a polycarbonate plastic.

15. The conductor pass-through device of any claim 9 to 14, wherein the conductor pass-through device comprises a non-rigid material.
